# EUROPEAN PATENT APPLICATION

(11) **EP 4 589 653 A1**
(43) Date of publication of application: **23.07.2025**
(21) Application number: 24214526.6
(22) Date of filing: 21.11.2024
(51) Int. Cl.: H01L 23/367, H01L 23/433, H01L 23/13, H01L 23/48, H01L 23/498, H01L 23/31

(54) **SEMICONDUCTOR PACKAGE STRUCTURE**

(30) Priority: 17.01.2024 US 202463621613 P; 19.09.2024 US 202418889774
(71) Applicant: MediaTek Inc., Hsinchu City, 30078 (TW)
(72) Inventor: CHIU, Sang-Mao, 30078 Hsinchu City (TW); CHEN, Yin-Fa, 30078 Hsinchu City (TW); YANG, Bo-Jiun, 30078 Hsinchu City (TW); TSAI, Wen-Chin, 30078 Hsinchu City (TW); WANG, Kai-Cheng, 30078 Hsinchu City (TW); CHEN, Tai-Yu, 30078 Hsinchu City (TW); CHEN, Chi-Yuan, 30078 Hsinchu City (TW); YU, Ta-Jen, 30078 Hsinchu City (TW); LIN, Ping-Yeh, 30078 Hsinchu City (TW)
(74) Representative: Haseltine Lake Kempner LLP

(57) **Abstract**

A semiconductor package structure includes a substrate, a semiconductor die, an interposer, a heat spreader, and an adhesive layer. The semiconductor die is disposed over the substrate. The interposer is disposed over the semiconductor die and has a cavity. The heat spreader is embedded in the interposer and vertically overlaps the semiconductor die. The adhesive layer is disposed in the cavity and connects the semiconductor die to the heat spreader.

## Description

This application claims the benefit of U.S. Provisional Application No. 63/621,613 filed on January 17, 2024, the entirety of which is incorporated by reference herein.

### BACKGROUND OF THE INVENTION

### Field of the Invention

The present invention is related to semiconductor packaging technology, and in particular to a semiconductor package structure.

### Description of the Related Art

A semiconductor package structure can not only provide a semiconductor die with protection from environmental contaminants, but it can also provide an electrical connection between the semiconductor die packaged therein and a substrate, such as a printed circuit board (PCB). With the increase in demand for smaller devices that can perform more functions, package-on-package (PoP) technology has become increasingly popular. PoP technology vertically stacks two or more package structures so that the amount of area that it takes up on the motherboard can be reduced.

Although existing semiconductor package structures generally meet requirements, however, they are not satisfactory in every respect. For example, if the heat which is generated during the operation of the semiconductor die is not adequately removed, the increased temperatures may result in damage to semiconductor components. Thermal dissipation is a critical problem that needs to be solved since it affects the performance of semiconductor package structures. Therefore, further improvements in semiconductor package structures are required.

### BRIEF SUMMARY OF THE INVENTION

Semiconductor package structures are provided. An exemplary embodiment of a semiconductor package structure includes a substrate, a semiconductor die, an interposer, a heat spreader, and an adhesive layer. The semiconductor die is disposed over the substrate. The interposer is disposed over the semiconductor die and has a cavity. The heat spreader is embedded in the interposer and vertically overlaps the semiconductor die. The adhesive layer is disposed in the cavity and connects the semiconductor die to the heat spreader.

Another exemplary embodiment of a semiconductor package structure includes a substrate, a semiconductor die, an interposer, a heat spreader, and a conductive structure. The semiconductor die is disposed over the substrate. The interposer includes a first portion covering the semiconductor die and a second portion connecting the first portion. The second portion is thicker than the first portion. The heat spreader is disposed in the first portion of the interposer. The conductive structure is partially disposed in the second portion of the interposer and electrically couples the substrate to the interposer.

Yet another exemplary embodiment of a semiconductor package structure includes a first redistribution structure, a semiconductor die, an adhesive layer, a heat spreader, a second redistribution structure, and a molding material. The semiconductor die is disposed over the first redistribution structure. The adhesive layer is disposed over the semiconductor die. The heat spreader is disposed over the adhesive layer and vertically overlaps the semiconductor die. The second redistribution structure is disposed over the heat spreader. The molding material surrounds the semiconductor die, the adhesive layer, and the heat spreader.

### BRIEF DESCRIPTION OF THE DRAWINGS

The present invention can be more fully understood by reading the subsequent detailed description and examples with references made to the accompanying drawings, wherein:
FIGs. 1A to 1C are cross-sectional views illustrating a semiconductor package structure at various stages of manufacture in accordance with some embodiments of the present disclosure;
FIGs. 2, 3, 4, 5, 6 and 7 are cross-sectional views illustrating semiconductor package structures in accordance with some embodiments of the present disclosure;
FIGs. 8A to 8B are cross-sectional views illustrating a semiconductor package structure at various stages of manufacture in accordance with some embodiments of the present disclosure;
FIGs. 9A to 9B are cross-sectional views illustrating a semiconductor package structure at various stages of manufacture in accordance with some embodiments of the present disclosure;
FIGs. 10A to 10C are cross-sectional views illustrating a semiconductor package structure at various stages of manufacture in accordance with some embodiments of the present disclosure; and
FIGs. 11A to 11B are cross-sectional views illustrating a semiconductor package structure at various stages of manufacture in accordance with some embodiments of the present disclosure.

### DETAILED DESCRIPTION OF THE INVENTION

The following description is made for the purpose of illustrating the general principles of the invention and should not be taken in a limiting sense. The scope of the invention is best determined by reference to the appended claims.

The present disclosure will be described with respect to particular embodiments and with reference to certain drawings, but the disclosure is not limited thereto and is only limited by the claims. The drawings described are only schematic and are non-limiting. In the drawings, the size of some of the elements may be exaggerated for illustrative purposes and not drawn to scale. The dimensions and the relative dimensions do not correspond to actual dimensions in the practice of the disclosure.

Additional elements may be added on the basis of the embodiments described below. For example, the description of "forming a first element over a second element" may include embodiments in which the first element is in direct contact with the second element, and may also include embodiments in which additional elements are disposed between the first element and the second element such that the first element and the second element are not in direct contact.

Spatially relative descriptors of the first element and the second element may change as the device is operated or used in different orientations. In addition, the present disclosure may repeat reference numerals and/or letters in the various embodiments. This repetition is for simplicity and clarity and does not in itself dictate a relationship between the various embodiments discussed.

A semiconductor package structure with enhanced efficiency of thermal dissipation is described in accordance with some embodiments of the present disclosure. The thermal dissipation path can be shortened, and thus the performance of the semiconductor package structure can be improved. The present disclosure can be adopted as a phone thermal solution.

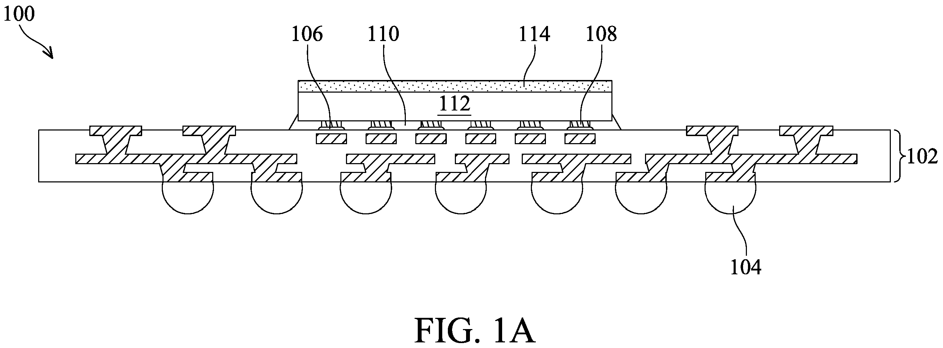

FIGs. 1A to 1C are cross-sectional views illustrating a semiconductor package structure 100 at various stages of manufacture in accordance with some embodiments of the present disclosure. Additional features can be added to the semiconductor package structure 100. Some of the features described below can be replaced or eliminated for different embodiments. To simplify the diagram, only a portion of the semiconductor package structure 100 is illustrated.

As illustrated in FIG. 1A, a package substrate 102 is provided, in accordance with some embodiments. The package substrate 102 may have a wiring structure therein. In some embodiments, the wiring structure of the package substrate 102 includes conductive layers, conductive vias, conductive pillars, the like, or a combination thereof. The wiring structure of the package substrate 102 may be formed of metal, including copper, aluminum, tungsten, the like, an alloy thereof, or a combination thereof.

The wiring structure of the package substrate 102 may be disposed in passivation layers. The passivation layers may be formed of polymers, including polyimide (PI), polybenzoxazole (PBO), benzocyclobutene (BCB), epoxy, the like, or a combination thereof. Alternatively, the passivation layers may be formed of dielectric materials, including silicon oxide, silicon carbide, silicon nitride, silicon oxynitride, the like, or a combination thereof.

It should be noted that the configuration of the package substrate 102 shown in the figures is exemplary only and is not intended to limit the present disclosure. Any desired semiconductor element may be formed in and on the package substrate 102. However, in order to simplify the diagram, only the flat substrate 102 is illustrated.

As shown in FIG. 1A, the semiconductor package structure 100 includes a plurality of conductive terminals 104 disposed below the package substrate 102 and electrically coupled to the wiring structure of the package substrate 102, in accordance with some embodiments. The conductive terminals 104 may include microbumps, controlled collapse chip connection (C4) bumps, solder balls, ball grid array (BGA) balls, the like, or a combination thereof. In some embodiments, the conductive terminals 104 are formed of conductive material, including copper, aluminum, tungsten, the like, an alloy thereof, or a combination thereof.

As further shown in FIG. 1A, the semiconductor package structure 100 includes a semiconductor die 112 disposed over the package substrate 102, in accordance with some embodiments. In some embodiments, the semiconductor die 112 includes a system-on-chip (SoC) die, a logic device, a memory device, a radio frequency (RF) device, the like, or any combination thereof. For example, the semiconductor die 112 may include a micro control unit (MCU) die, a microprocessor unit (MPU) die, a power management integrated circuit (PMIC) die, a radio frequency front end (RFFE) die, an accelerated processing unit (APU) die, a central processing unit (CPU) die, a graphics processing unit (GPU) die, an input-output (IO) die, a dynamic random access memory (DRAM) controller, a static random-access memory (SRAM), a high bandwidth memory (HBM), an application processor (AP) die, the like, or any combination thereof.

According to some embodiments, the semiconductor package structure 100 may include more than one semiconductor dies. In addition, the semiconductor package structure 100 may also include one or more passive components (not illustrated) adjacent to the semiconductor die 112, such as resistors, capacitors, inductors, the like, or a combination thereof.

The semiconductor die 112 may be electrically coupled to the wiring structure of the package substrate 102 through a plurality of conductive structures 108 and a plurality of connectors 106. As shown in FIG. 1A, the conductive structures 108 may be disposed below the semiconductor die 112, and may be bonded to the package substrate 102 through the connectors 106.

In some embodiments, the conductive structures 108 include conductive pads, conductive pillars, the like, or a combination thereof. The conductive structures 108 may be formed of conductive materials, including copper, aluminum, tungsten, titanium, tantalum, the like, an alloy thereof, or a combination thereof. The conductive structures 108 may be formed by electroplating, electroless plating, or another applicable process.

In some embodiments, the connectors 106 are formed of solder materials, including tin, SnAg, SnPb, the like, or a combination thereof. The connectors 106 may be formed by electroplating, electroless plating, or another applicable process.

As illustrated in FIG. 1A, the semiconductor package structure 100 includes an underfill material 110 between the package substrate 102 and the semiconductor die 112, in accordance with some embodiments. The underfill material 110 may fill in gaps between the conductive structures 108 and the connectors 106 and surround each of them to provide structural support. In some embodiments, the underfill material 110 is formed of polymer, such as epoxy. The underfill material 110 may be dispensed with capillary force, and then be cured through any suitable curing process.

As shown in FIG. 1A, the semiconductor package structure 100 includes an adhesive layer 114 disposed over the semiconductor die 112, in accordance with some embodiments. The adhesive layer 114 may cover the entire top surface the semiconductor die 112. In some embodiments, the adhesive layer 114 includes conductive paste (CP), non-conductive paste (NCP), high-k film, epoxy, or another applicable material. The sidewalls of the adhesive layer 114 may be substantially coplanar with the sidewalls of the semiconductor die 112.

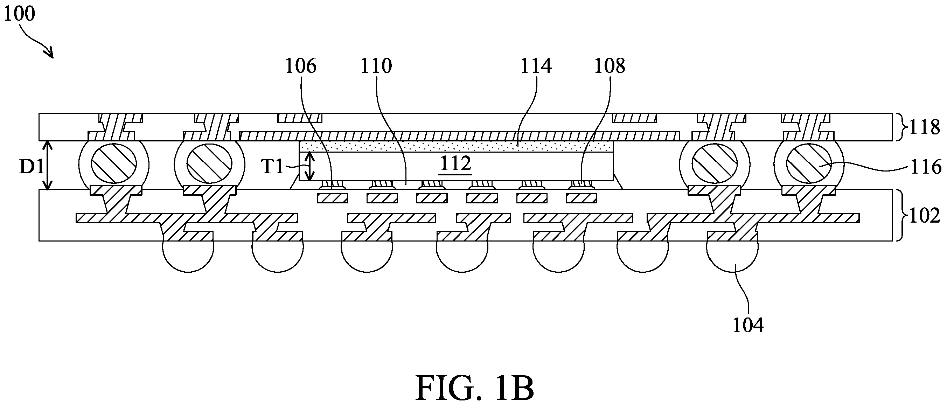

As illustrated in FIG. 1B, an interposer 118 is bonded onto the semiconductor die 112 through the adhesive layer 114, in accordance with some embodiments. The thickness of the semiconductor die 112 is increased to gain power budget enhancement. In addition, the semiconductor die 112 is thick enough to connect the interposer 118, so that the heat from the thermal source (e.g., the semiconductor die 112) can be transferred to the interposer 118 through the adhesive layer 114. Consequently, the thermal dissipation path can be shortened.

According to some embodiments, the ratio of the thickness T1 of the semiconductor die 112 in the direction substantially vertical to the top surface of the package substrate 102 to the distance D1 between the interposer 118 and the package substrate 102 is in a range of about 0.5 to about 0.95, such as about 0.9.

The adhesive layer 114 may be disposed on the semiconductor die 112 before bonding the interposer 118 to the semiconductor die 112 as illustrated, but the present disclosure is not limited thereto. As an example, the adhesive layer 114 may be disposed on the interposer 118 before bonding the interposer 118 to the semiconductor die 112. As another example, the adhesive layer 114 may be disposed on both of the interposer 118 and the semiconductor die 112 before bonding the interposer 118 to the semiconductor die 112.

The interposer 118 may have a wiring structure therein. In some embodiments, the wiring structure of the interposer 118 includes conductive layers, conductive vias, conductive pillars, the like, or a combination thereof. The wiring structure of the interposer 118 may be formed of metal, including copper, aluminum, tungsten, the like, an alloy thereof, or a combination thereof.

The wiring structure of the interposer 118 may be disposed in passivation layers. The passivation layers may be formed of polymers, including polyimide (PI), polybenzoxazole (PBO), benzocyclobutene (BCB), epoxy, the like, or a combination thereof. Alternatively, the passivation layers may be formed of dielectric materials, including silicon oxide, silicon carbide, silicon nitride, silicon oxynitride, the like, or a combination thereof.

As shown in FIG. 1B, the semiconductor package structure 100 includes a plurality of conductive structures 116 disposed between the package substrate 102 and the interposer 118, in accordance with some embodiments. The wiring structure of the interposer 118 may be electrically coupled to the wiring structure of the package substrate 102 through the conductive structures 116. In some embodiments, the conductive structures 116 include conductive pillars, solder balls, copper core solder balls, the like, or a combination thereof. The conductive structures 116 may be formed of conductive materials, including copper, aluminum, tungsten, the like, an alloy thereof, or a combination thereof.

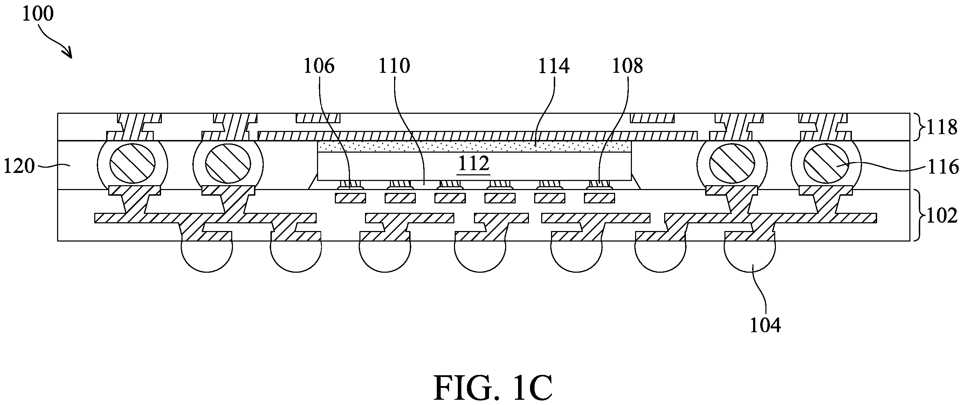

As illustrated in FIG. 1C, the semiconductor package structure 100 includes a molding material 120 surrounding the semiconductor die 112, the adhesive layer 114, the underfill material 110, and the conductive structures 116, in accordance with some embodiments. The molding material 120 may include a nonconductive material, such as a moldable polymer, an epoxy, a resin, the like, or a combination thereof.

The molding material 120 may protect the semiconductor die 112, the adhesive layer 114, and the conductive structures 116 from the environment, thereby preventing these components from damage due to stress, chemicals, and moisture. As shown in FIG. 1C, the sidewalls of the molding material 120 may be substantially coplanar with the sidewalls of the package substrate 102 and the sidewalls of the interposer 120.

In some embodiments where a semiconductor die is not thick enough for bonding to an interposer, a portion of a molding material is disposed therebetween. In these embodiments, since the gap between the semiconductor die and the interposer is narrow, some voids might be formed therein. In addition, the low thermal conductivity of the molding material makes it difficult to dissipate heat. In contrast, the present disclosure includes a thicker semiconductor die 112 and connects the semiconductor die 112 to the interposer 118 using the adhesive layer 114. Therefore, voids between the semiconductor die 112 and the interposer 118 can be reduced or avoided. Moreover, since the adhesive layer 114 has a higher thermal conductivity than the molding material 120, the efficiency of thermal dissipation can be further improved.

Additionally, the semiconductor die 112 can provide a stronger support than the molding material 120, so that the semiconductor package structure 100 can have a better warpage behavior.

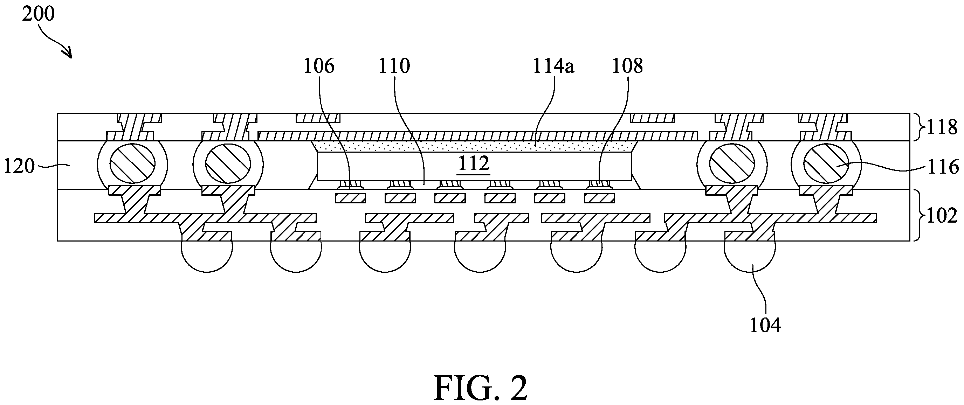

As described above, the sidewalls of the adhesive layer 114 may be substantially coplanar with the sidewalls of the semiconductor die 112, as shown in FIG. 1C, but the present disclosure is not limited thereto. As an example, a semiconductor package structure 200 includes an adhesive layer 114a which may extend outside the sidewalls of the semiconductor die 112, as shown in FIG. 2. The sidewalls of the adhesive layer 114a may be tapered. In particular, the adhesive layer 114a may have a larger projection area than the semiconductor die 112.

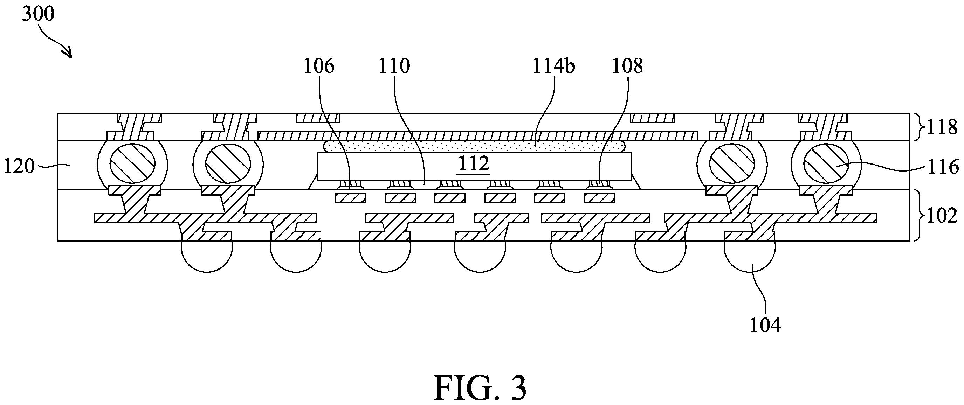

As another example, a semiconductor package structure 300 includes an adhesive layer 114b which may have sidewalls between the sidewalls of the semiconductor die 112, as shown in FIG. 3. The sidewalls of the adhesive layer 114b may be rounded. In particular, the semiconductor die 112 may have a larger projection area than the adhesive layer 114b.

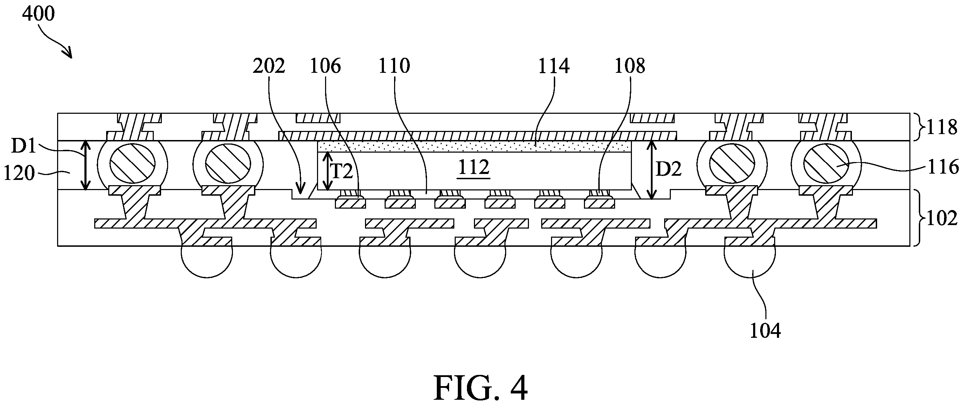

FIG. 4 is a cross-sectional view illustrating a semiconductor package structure 400 in accordance with some embodiments of the present disclosure. It should be noted that the semiconductor package structure 400 may include the same or similar components as that of the semiconductor package structure 100, which is illustrated in FIG. 1C, and for the sake of simplicity, those components will not be discussed in detail again. In the following embodiments, the package substrate has a recess for accommodating a thicker semiconductor die.

As illustrated in FIG. 4, the package substrate 102 has a recess 202, and the semiconductor die 112 is disposed directly above the recess 202, in accordance with some embodiments. In particular, the semiconductor die 112 may be disposed in the thinner region of the package substrate 102. As a result, the thickness of the semiconductor die 112 can be further increased for enhancing the thermal dissipation.

As shown in FIG. 4, the package substrate 102 may have a first top surface (i.e., the bottom surface of the recess 202) directly below the semiconductor die 112 and a second top surface in contact with the conductive structures 116. The first top surface and the second top surface of the package substrate 102 may form a stepped shape.

According to some embodiments, in regions without the recess 202, the ratio of the thickness T2 of the semiconductor die 112 in the direction substantially vertical to the top surface of the package substrate 102 to the distance D1 between the interposer 118 and the package substrate 102 is in a range of about 0.5 to about 0.98, such as about 0.9. According to some embodiments, in regions with the recess 202, the ratio of the thickness T2 of the semiconductor die 112 to the distance D2 between the interposer 118 and the package substrate 102 is in a range of about 0.5 to about 0.95, such as about 0.9. The distance D2 may be greater than the distance D1. According to some embodiments, the ratio of the distance D2 to the distance D1 is in a range of about 1.05 to about 1.5, such as about 1.07.

As further shown in FIG. 4, the sidewalls of the recess 202 may be substantially vertical to the second top surface of the package substrate 102, but the present disclosure is not limited thereto. For example, at least one of the sidewalls of the recess 202 may be tapered or sloped.

As illustrated in FIG. 4, the conductive structures 108, the connectors 106, and the underfill material 110 may be disposed in the recess 202, and a portion of the molding material 120 may extend into the recess 202. However, this may vary depending on the dimension or shape of the recess 202. For example, in some other embodiments, the underfill material 110 may fully fill the recess 202, and the molding material 120 may not extend into the recess 202.

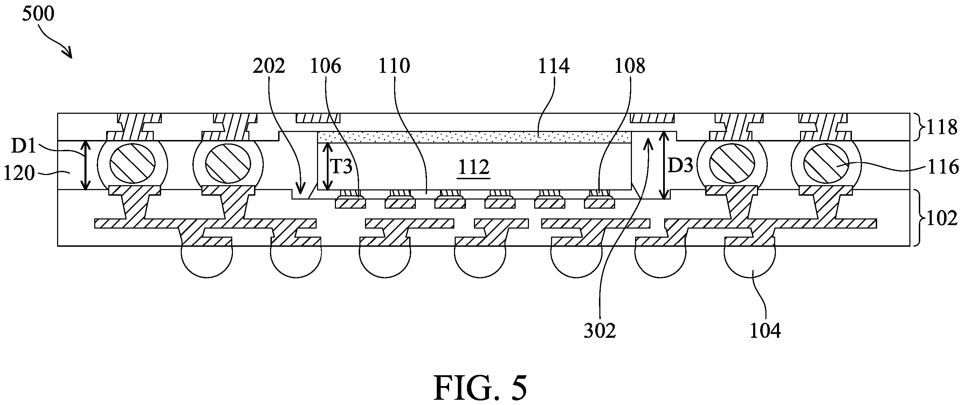

FIG. 5 is a cross-sectional view illustrating a semiconductor package structure 500 in accordance with some embodiments of the present disclosure. It should be noted that the semiconductor package structure 500 may include the same or similar components as that of the semiconductor package structure 100, which is illustrated in FIG. 1C, and for the sake of simplicity, those components will not be discussed in detail again. In the following embodiments, both of the package substrate and the interposer have recesses for accommodating a thicker semiconductor die.

As illustrated in FIG. 5, the package substrate 102 has a recess 202, and the interposer 118 has a recess 302 directly above the recess 202, in accordance with some embodiments. The semiconductor die 112 may be disposed between the recess 202 and the recess 302. In particular, the semiconductor die 112 may be disposed between the thinner region of the package substrate 102 and the thinner region of the interposer 118. As a result, the thickness of the semiconductor die 112 can be further increased for improving the thermal dissipation.

As shown in FIG. 5, the interposer 118 may have a first bottom surface in contact with the adhesive layer 114 (i.e., the bottom surface of the recess 302) and a second bottom surface in contact with the conductive structures 116. The first bottom surface and the second bottom surface of the interposer 118 may form a stepped shape.

As further shown in FIG. 5, the package substrate 102 may have a first top surface (i.e., the bottom surface of the recess 202) directly below the semiconductor die 112 and a second top surface in contact with the conductive structures 116. The first top surface and the second top surface of the package substrate 102 may form a stepped shape.

As illustrated in FIG. 5, the recess 302 may have a larger projection area than the recess 202, but the present disclosure is not limited thereto. For example, the recess 202 may have a larger projection area than the recess 302. Alternatively, the dimension of the recess 202 may be substantially equal to the dimension of the recess 302.

According to some embodiments, in regions without the recess 202 and the recess 302, the ratio of the thickness T3 of the semiconductor die 112 in the direction substantially vertical to the top surface of the package substrate 102 to the distance D1 between the interposer 118 and the package substrate 102 is in a range of about 0.5 to about 1.5, such as about 1. According to some embodiments, in regions with the recess 202 and the recess 302, the ratio of the thickness T3 of the semiconductor die 112 to the distance D3 between the interposer 118 and the package substrate 102 is in a range of about 0.5 to about 0.95, such as about 0.85. The distance D3 may be greater than the distance D1. According to some embodiments, the ratio of the distance D3 to the distance D1 is in a range of about 1.05 to about 1.5, such as about 1.07.

As shown in FIG. 5, the sidewalls of the recess 202 may be substantially vertical to the second top surface of the package substrate 102, and the sidewalls of the recess 302 may be substantially vertical to the second bottom surface of the interposer 118, but the present disclosure is not limited thereto. For example, at least one of the sidewalls of the recess 202 and the sidewalls of the recess 302 may be tapered or sloped.

As further shown in FIG. 5, the conductive structures 108, the connectors 106, and the underfill material 110 may be disposed in the recess 202. A portion of the molding material 120 may extend into the recess 202 and may cover the sidewalls of the recess 202. However, this may vary depending on the dimension or shape of the recess 202. For example, in some other embodiments, the underfill material 110 may fully fill the recess 202, and the molding material 120 may not extend into the recess 202.

As illustrated in FIG. 5, the bottom surface of the recess 302 may have a larger projection area than the adhesive layer 114. A portion of the molding material 120 may extend into the recess 302 and may cover the sidewalls of the recess 302. However, this may vary depending on the dimension or shape of the recess 302. For example, in some other embodiments, the adhesive layer 114 may fully fill the recess 302, and the molding material 120 may not extend into the recess 302.

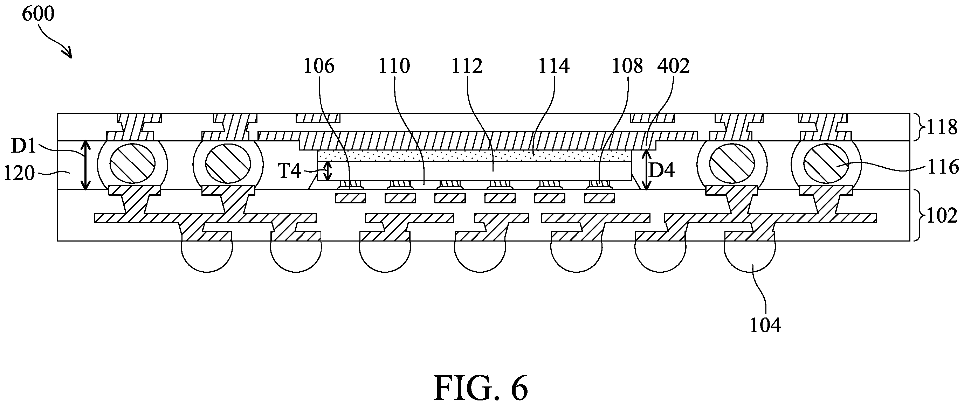

FIG. 6 is a cross-sectional view illustrating a semiconductor package structure 600 in accordance with some embodiments of the present disclosure. It should be noted that the semiconductor package structure 600 may include the same or similar components as that of the semiconductor package structure 100, which is illustrated in FIG. 1C, and for the sake of simplicity, those components will not be discussed in detail again. In the following embodiments, the interposer has a mesa structure to facilitate heat transfer from the semiconductor die.

As illustrated in FIG. 6, the interposer 118 has a mesa structure 402, and the semiconductor die 112 is disposed directly below the mesa structure 402, in accordance with some embodiments. In particular, the semiconductor die 112 may be disposed in the thicker region of the interposer 118.

According to some embodiments, the mesa structure 402 includes an embedded heat sink. The mesa structure 402 may be formed of metal, including copper, aluminum, tungsten, the like, an alloy thereof, or a combination thereof. In some embodiments, the mesa structure 402 is a portion of the wiring structure of the interposer 118 and is formed during the formation of the wiring structure of the interposer 118. In some other embodiments, the mesa structure 402 is formed after the formation of the wiring structure of the interposer 118.

As shown in FIG. 6, the interposer 118 may have a first bottom surface (i.e., the bottom surface of the mesa structure 402) directly above the semiconductor die 112 and a second bottom surface in contact with the conductive structures 116. The first bottom surface and the second bottom surface of the interposer 118 may form a stepped shape.

According to some embodiments, in regions without the mesa structure 402, the ratio of the thickness T4 of the semiconductor die 112 in the direction substantially vertical to the top surface of the package substrate 102 to the distance D1 between the interposer 118 and the package substrate 102 is in a range of about 0.2 to about 0.95, such as about 0.8. According to some embodiments, in regions with the mesa structure 402, the ratio of the thickness T4 of the semiconductor die 112 to the distance D4 between the interposer 118 and the package substrate 102 is in a range of about 0.25 to about 0.95, such as about 0.85. The distance D4 may be less than the distance D1. According to some embodiments, the ratio of the distance D4 to the distance D1 is in a range of about 0.65 to about 0.98, such as about 0.95.

As further shown in FIG. 6, the sidewalls of the mesa structure 402 may be substantially vertical to the second bottom surface of the interposer 118, but the present disclosure is not limited thereto. For example, at least one of the sidewalls of the mesa structure 402 may be tapered or sloped.

The mesa structure 402 may be surrounded by the molding material 120. As shown in FIG. 6, the mesa structure 402 may have a larger projection area than the adhesive layer 114 and the semiconductor die 112, but the present disclosure is not limited thereto. As an example, the adhesive layer 114 and/or the semiconductor die 112 may have a larger projection area than the mesa structure 402. As another example, the sidewalls of the mesa structure 402 may be aligned with the sidewalls of the adhesive layer 114 and/or the sidewalls of the semiconductor die 112.

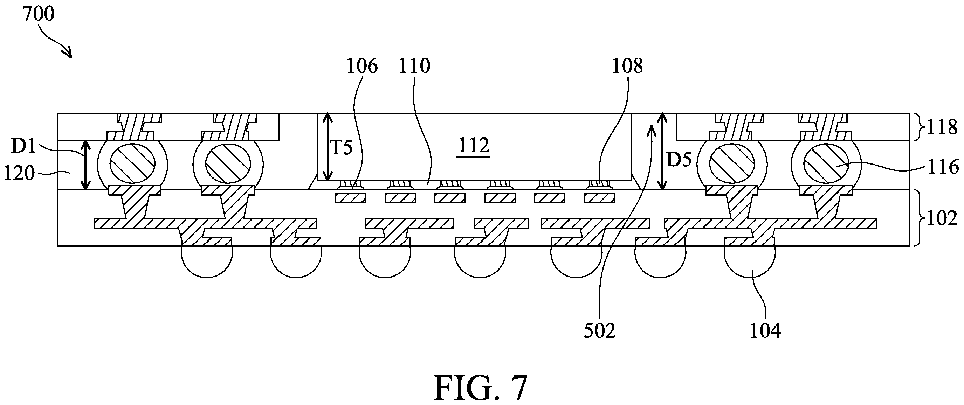

FIG. 7 is a cross-sectional view illustrating a semiconductor package structure 700 in accordance with some embodiments of the present disclosure. It should be noted that the semiconductor package structure 700 may include the same or similar components as that of the semiconductor package structure 100, which is illustrated in FIG. 1C, and for the sake of simplicity, those components will not be discussed in detail again. In the following embodiments, the interposer has a cavity for accommodating a thicker semiconductor die.

As illustrated in FIG. 7, the interposer 118 has a cavity 502, and the semiconductor die 112 is disposed in the cavity 502, in accordance with some embodiments. The thickness of the semiconductor die 112 can be further increased for improving the thermal dissipation.

According to some embodiments, in regions without the cavity 502, the ratio of the thickness T5 of the semiconductor die 112 in the direction substantially vertical to the top surface of the package substrate 102 to the distance D1 between the interposer 118 and the package substrate 102 is in a range of about 0.85 to about 1.5, such as about 1.2. According to some embodiments, in regions with the cavity 502, the ratio of the thickness T5 of the semiconductor die 112 to the distance D5 between the interposer 118 and the package substrate 102 is in a range of about 0.75 to about 0.95, such as about 0.85. The distance D5 may be greater than the distance D1. According to some embodiments, the ratio of the distance D5 to the distance D1 is in a range of about 1.15 to about 1.5, such as about 1.45.

As shown in FIG. 7, the cavity 502 may extend through interposer 118. In particular, the cavity 502 may extend from the bottom surface of the interposer 118 to the top surface of the interposer 118. The sidewalls of the cavity 502 may be substantially vertical to the bottom surface of the interposer 118, but the present disclosure is not limited thereto. For example, at least one of the sidewalls of the cavity 502 may be tapered or sloped. The molding material 120 may extend into the cavity 502 and may cover the sidewalls of the cavity 502. The top surface of the interposer 118 and the top surface of the molding material 120 may be substantially coplanar.

In some embodiments, the top surface of the semiconductor die 112 is exposed to increase the efficiency of thermal dissipation, as shown in FIG. 7. The top surface of the semiconductor die 112 may be substantially coplanar with the top surface of the interposer 118 and the top surface of the molding material 120. The dimension (such as the width) of the cavity 502 may be greater than the dimension (such as the width) of the semiconductor die 112.

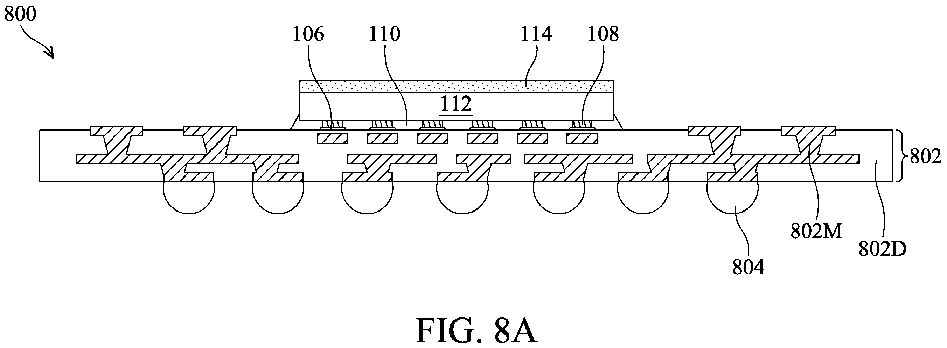

FIGs. 8A to 8B are cross-sectional views illustrating a semiconductor package structure 800 at various stages of manufacture in accordance with some embodiments of the present disclosure. Additional features can be added to the semiconductor package structure 800. Some of the features described below can be replaced or eliminated for different embodiments. To simplify the diagram, only a portion of the semiconductor package structure 800 is illustrated.

As illustrated in FIG. 8A, a substrate 802 is provided, in accordance with some embodiments. The substrate 802 may be a package substrate. For example, the substrate 802 may be a printed circuit board (PCB). The substrate 802 may have a wiring structure 802M therein. In some embodiments, the wiring structure 802M includes conductive layers, conductive vias, conductive pillars, the like, or a combination thereof. The wiring structure 802M may be formed of metal, including copper, aluminum, tungsten, the like, an alloy thereof, or a combination thereof.

The wiring structure 802M may be disposed in dielectric layers 802D. The dielectric layers 802D may be formed of polymers, including polyimide (PI), polybenzoxazole (PBO), benzocyclobutene (BCB), epoxy, the like, or a combination thereof. Alternatively, the dielectric layers 802D may be formed of dielectric materials, including silicon oxide, silicon carbide, silicon nitride, silicon oxynitride, the like, or a combination thereof.

It should be noted that the configuration of the substrate 802 shown in the figures is exemplary only and is not intended to limit the present disclosure. Any desired semiconductor element may be formed in and on the substrate 802. However, in order to simplify the diagram, only the flat substrate 802 is illustrated.

A plurality of conductive terminals 804 are disposed below the substrate 802, in accordance with some embodiments. The conductive terminals 804 may be electrically coupled to the wiring structure 802M. The conductive terminals 804 may include microbumps, controlled collapse chip connection (C4) bumps, solder balls, ball grid array (BGA) balls, the like, or a combination thereof. In some embodiments, the conductive terminals 804 are formed of conductive materials, including tungsten, titanium, tantalum, ruthenium, cobalt, copper, aluminum, platinum, tin, silver, gold, the like, an alloy thereof, or a combination thereof.

A semiconductor die 112 is disposed over the substrate 802, in accordance with some embodiments. In some embodiments, the semiconductor die 112 includes a system-on-chip (SoC) die, a logic device, a memory device, a radio frequency (RF) device, the like, or any combination thereof. For example, the semiconductor die 112 may include a micro control unit (MCU) die, a microprocessor unit (MPU) die, a power management integrated circuit (PMIC) die, a radio frequency front end (RFFE) die, an accelerated processing unit (APU) die, a central processing unit (CPU) die, a graphics processing unit (GPU) die, an input-output (IO) die, a dynamic random access memory (DRAM) controller, a static random-access memory (SRAM), a high bandwidth memory (HBM), an application processor (AP) die, the like, or any combination thereof.

According to some embodiments, more than one semiconductor dies may be disposed over the substrate 802. In addition, one or more passive components (not illustrated) may be disposed over the substrate 802 and adjacent to the semiconductor die 112, including resistors, capacitors, inductors, the like, or a combination thereof.

The semiconductor die 112 may be electrically coupled to the wiring structure 802M through a plurality of conductive structures 108 and a plurality of connectors 106. The conductive structures 108 may be disposed below the semiconductor die 112, and may be bonded to the substrate 802 through the connectors 106.

In some embodiments, the conductive structures 108 include conductive pads, conductive pillars, the like, or a combination thereof. The conductive structures 108 may be formed of conductive materials, including copper, aluminum, tungsten, titanium, tantalum, the like, an alloy thereof, or a combination thereof. The conductive structures 108 may be formed by electroplating, electroless plating, or another applicable process.

In some embodiments, the connectors 106 are formed of solder materials, including tin, SnAg, SnPb, the like, or a combination thereof. The connectors 106 may be formed by electroplating, electroless plating, or another applicable process.

An underfill material 110 is formed between the substrate 802 and the semiconductor die 112, in accordance with some embodiments. The underfill material 110 may fill in gaps between the conductive structures 108 and the connectors 106 and may surround each of them to provide structural support. In some embodiments, the underfill material 110 is formed of polymer, such as epoxy. The underfill material 110 may be dispensed with capillary force, and then be cured through any suitable curing process. The underfill material 110 may partially cover the sidewalls of the semiconductor die 112.

An adhesive layer 114 is formed over the semiconductor die 112, in accordance with some embodiments. The adhesive layer 114 may cover the entire top surface the semiconductor die 112. In some embodiments, the adhesive layer 114 includes conductive paste (CP), non-conductive paste (NCP), high-k film, epoxy, or another applicable material. The sidewalls of the adhesive layer 114 may be substantially coplanar with the sidewalls of the semiconductor die 112.

The present disclosure is not limited thereto. Similar to those discussed previously, according to an embodiment, the adhesive layer 114 may extend outside the sidewalls of the semiconductor die 112, such as the semiconductor package structure 200 in FIG. 2. Alternatively, according to another example, the adhesive layer 114 may have sidewalls between the sidewalls of the semiconductor die 112, such as the semiconductor package structure 300 in FIG. 3.

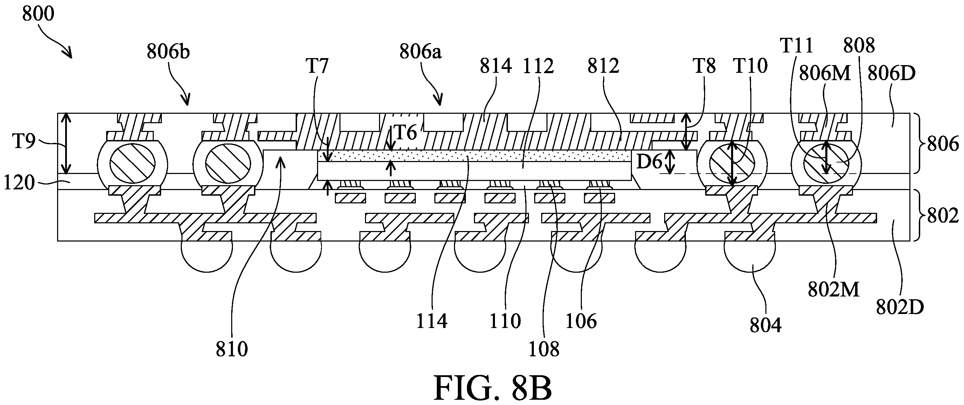

Then, as illustrated in FIG. 8B, an interposer 806 is bonded onto the semiconductor die 112, in accordance with some embodiments. The interposer 806 may be in direct contact with the adhesive layer 114, so that the heat from the thermal source (e.g., the semiconductor die 112) can be transferred to the interposer 806 through the adhesive layer 114.

The adhesive layer 114 may be disposed on the semiconductor die 112 before bonding the interposer 806 to the semiconductor die 112 as illustrated. However, the present disclosure is not limited thereto. As an example, the adhesive layer 114 may be disposed on the interposer 806 before bonding the interposer 118 to the semiconductor die 112. As another example, the adhesive layer 114 may be disposed on both of the interposer 806 and the semiconductor die 112 before bonding the interposer 806 to the semiconductor die 112.

The interposer 806 may have a wiring structure 806M therein. In some embodiments, the wiring structure 806M includes conductive layers, conductive vias, conductive pillars, the like, or a combination thereof. The wiring structure 806M may be formed of metal, including copper, aluminum, tungsten, the like, an alloy thereof, or a combination thereof.

The wiring structure 806M may be disposed in dielectric layers 806D. The dielectric layers 806D may be formed of polymers, including polyimide (PI), polybenzoxazole (PBO), benzocyclobutene (BCB), epoxy, the like, or a combination thereof. Alternatively, the dielectric layers 806D may be formed of dielectric materials, including silicon oxide, silicon carbide, silicon nitride, silicon oxynitride, the like, or a combination thereof.

The interposer 806 may have a cavity 810. The semiconductor die 112 and the adhesive layer 114 may be disposed in the cavity 810, so that the thickness of the semiconductor die 112 can be increased without increasing the total thickness of the semiconductor package structure 800. With the thicker semiconductor die 112, the efficiency of thermal dissipation can be enhanced. In additional, the thicker semiconductor die 112 can provide a stronger support, so that the warpage behavior of the semiconductor package structure 800 can be improved.

The cavity 810 may have a depth D6. In some embodiments, the depth D6 is in a range of about 20 µm to about 80 µm, such as about 50 µm. The depth D6 may be greater than the thickness T6 of the adhesive layer 114 and may be less than the sum of the thickness T6 of the adhesive layer 114 and the thickness T7 of the semiconductor die 112. The sidewalls of the cavity 810 may be substantially vertical to the bottom surface of the interposer 806, but the present disclosure is not limited thereto. For example, at least one of the sidewalls of the cavity 810 may be tapered or sloped.

The interposer 806 may have a first portion 806a and a second portion 806b, and in the direction substantially vertical to the top surface of the interposer 806, the thickness T8 of the first portion 806a may be less than the thickness T9 of the second portion 806b. In particular, the distance between the bottom surface of the second portion 806b and the bottom surface of the first portion 806a may be equal to the depth D6.

The second portion 806b may connect and surround the first portion 806a. The first portion 806a may vertically overlap the semiconductor die 112 and the adhesive layer 114. In some embodiments, the ratio of the thickness T8 of the first portion 806a to the thickness T9 of the second portion 806b is in a range of about 0.19 to about 0.29, such as about 0.23. Therefore, the total height requirements of package structure can be meet, while taking into account electrical properties and reasonable costs.

A heat spreader 812 is embedded in the first portion 806a of the interposer 806, in accordance with some embodiments. The bottom surface of the heat spreader 812 may be exposed, and the heat spreader 812 may be in direct contact with the adhesive layer 114. Therefore, the heat from the thermal source (e.g., the semiconductor die 112) can be transferred to the heat spreader 812 through the adhesive layer 114.

The heat spreader 812 may be formed of metal, including copper, aluminum, tungsten, the like, an alloy thereof, or a combination thereof. Since the heat spreader 812 is formed of the material with a higher thermal conductivity than the interposer 806, the efficiency of thermal dissipation can be further improved.

The bottom surface of the heat spreader 812 may be substantially aligned with the bottom surface of the first portion 806a of the interposer 806. The heat spreader 812 may vertically overlap the adhesive layer 114 and the hot spot of the semiconductor die 112. The heat spreader 812 may have a projection area substantially equal to or greater than the hot spot of the semiconductor die 112. In some embodiments, the heat spreader 812 has a projection area substantially equal to or greater than the adhesive layer 112 and/or the semiconductor die 112. By increasing the area of the heat spreader 1006, the efficiency of thermal dissipation can be further improved.

A plurality of thermal vias 814 are embedded in the first portion 806a of the interposer 806, in accordance with some embodiments. The thermal vias 814 may be disposed over and in direct contact with the heat spreader 812. The heat spreader 812 and the thermal vias 814 may be thermally coupled to the semiconductor die 112. Thus, the heat transferred to the heat spreader 812 from the semiconductor die 112 can be further transferred to the thermal vias 814.

The thermal vias 814 may be formed of metal, including copper, aluminum, tungsten, the like, an alloy thereof, or a combination thereof. The material of the thermal vias 814 may be similar to the material of the heat spreader 812. The material of the heat spreader 812 and the material of the thermal vias 814 may be similar to the material of the wiring structure 806M. In some embodiments, the heat spreader 812 and thermal vias 814 are formed during the formation of the wiring structure 806M.

The top surfaces of the thermal vias 814 may be exposed. The top surfaces of the thermal vias 814 may be substantially aligned with the top surface of the first portion 806a and may be substantially aligned with the top surface of the second portion 806b of the interposer 806.

A plurality of conductive structures 808 are disposed between the substrate 802 and the interposer 806, in accordance with some embodiments. The wiring structure 806M of the interposer 806 may be electrically coupled to the wiring structure 802M of the substrate 802 through the conductive structures 808. In some embodiments, the conductive structures 808 include copper core solder balls. In some other embodiments, the conductive structures 808 include conductive pillars, solder balls, any suitable structures, or a combination thereof. The conductive structures 808 may be formed of conductive materials, including copper, aluminum, tungsten, the like, an alloy thereof, or a combination thereof.

The conductive structures 808 may be partially disposed in the second portion 806b of the interposer 806 to decrease the total thickness of the semiconductor package structure 800. According to some embodiments, a plurality of openings (not illustrated) may be formed in the interposer 806 by laser drilling or any suitable methods, and then the conductive structures 808 may be formed in the openings.

In particular, the bottommost surface of the interposer 806 (or the bottom surface of the second portion 806b) may be disposed between the top surface and the bottom surface of the conductive structures 808. In some embodiments, in the direction substantially vertical to the top surface of the substrate 802, the ratio of the thickness T11 of the portion of one of the conductive structures 808 in the second portion 806b to the thickness T10 of the conductive structure 808 is in a range of about 0.1 to about 0.3, such as about 0.2. Therefore, the total height requirements of package structure can be meet, while taking into account electrical properties and reasonable costs.

Then, a molding material 120 is formed between the interposer 806 and the substrate 802, in accordance with some embodiments. The molding material 120 may extend into the cavity 810. In particular, the thickness of the molding material 120 directly below the first portion 806a of the interposer 806 may be greater than the thickness of the molding material 120 directly below the second portion 806b of the interposer 806.

The molding material 120 may be formed of a nonconductive material, including a moldable polymer, an epoxy, a resin, the like, or a combination thereof. The molding material 120 may surround the semiconductor die 112, the adhesive layer 114, the underfill material 110, and the conductive structures 808 to protect these components from the environment, thereby protecting them from damage due to stress, chemicals, and moisture.

In some embodiments, the molding material 120 is in direct contact with the bottom surface of the heat spreader 812. The sidewalls of the molding material 120 may be substantially coplanar with the sidewalls of the substrate 802 and the sidewalls of the interposer 806.

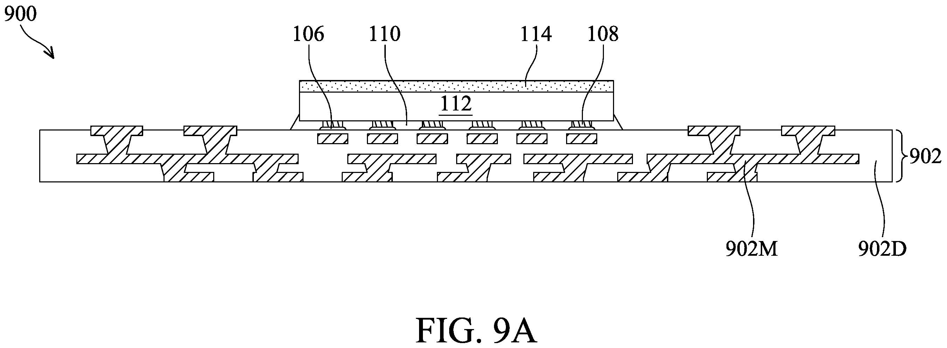

FIGs. 9A to 9B are cross-sectional views illustrating a semiconductor package structure 900 at various stages of manufacture in accordance with some embodiments of the present disclosure. It should be noted that the semiconductor package structure 900 may include the same or similar components as that of the semiconductor package structure 800, which is illustrated in FIG. 8B, and for the sake of simplicity, those components will not be discussed in detail again. In the following embodiments, a semiconductor die is disposed over a redistribution structure.

As shown in FIG. 9A, a substrate 902 is provided, in accordance with some embodiments. The substrate 902 may be a redistribution structure. The substrate 902 may have a wiring structure 902M therein. In some embodiments, the wiring structure 902M includes conductive layers, conductive vias, conductive pillars, the like, or a combination thereof. The wiring structure 902M may be formed of metal, including copper, aluminum, tungsten, the like, an alloy thereof, or a combination thereof.

The wiring structure 902M may be disposed in dielectric layers 902D. The dielectric layers 902D may be formed of polymers, including polyimide (PI), polybenzoxazole (PBO), benzocyclobutene (BCB), epoxy, the like, or a combination thereof. Alternatively, the dielectric layers 902D may be formed of dielectric materials, including silicon oxide, silicon carbide, silicon nitride, silicon oxynitride, the like, or a combination thereof.

Then, a semiconductor die 112, a plurality of connectors 106, a plurality of conductive structures 108, an underfill material 110, and an adhesive layer 114 are formed over the substrate 902, in accordance with some embodiments.

The interposer 806 may have a cavity 810. The semiconductor die 112 and the adhesive layer 114 may be disposed in the cavity 810, so that the thickness of the semiconductor die 112 can be increased, thereby improving the efficiency of thermal dissipation.

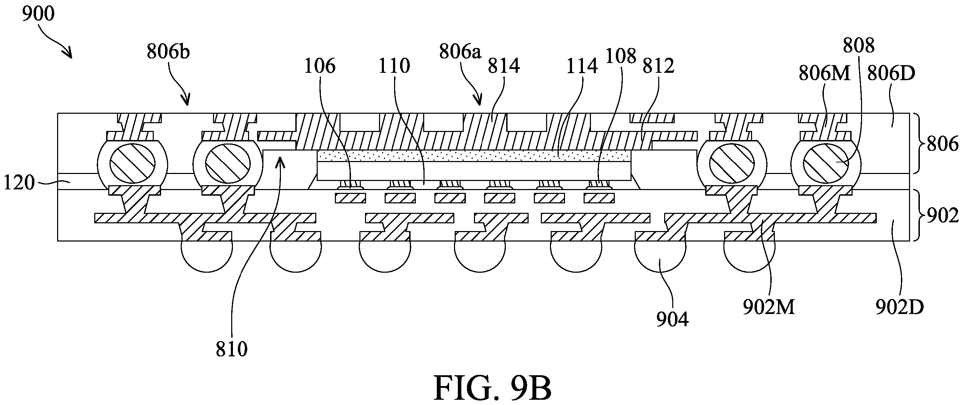

Afterwards, as illustrated in FIG. 9B, an interposer 806 is bonded onto the semiconductor die 112, in accordance with some embodiments. The interposer 806 may be in direct contact with the adhesive layer 114, so that the heat from the thermal source (e.g., the semiconductor die 112) can be transferred to the interposer 806 through the adhesive layer 114. Similar to those discussed above, the adhesive layer 114 may be disposed on the semiconductor die 112 and/or the interposer 806 before bonding the interposer 806 to the semiconductor die 112.

A heat spreader 812 and a plurality of thermal vias 814 are embedded in the first portion 806a of the interposer 806, in accordance with some embodiments. The heat spreader 812 may be in direct contact with the adhesive layer 114, and the thermal vias 814 may be in direct contact with the heat spreader 812. The heat spreader 812 may vertically overlap the semiconductor die 112, and may have a projection area substantially equal to or greater than the hot spot of the semiconductor die 112.

The heat spreader 812 and the thermal vias 814 may be thermally coupled to the semiconductor die 112. Thus, the heat from the semiconductor die 112 can be transferred to the heat spreader 812 through the adhesive layer 114, and can be further transferred to the thermal vias 814. Since the heat spreader 812 and the thermal vias 814 are formed of the material with a higher thermal conductivity than the interposer 806, the efficiency of thermal dissipation can be further improved.

A plurality of conductive structures 808 are formed between the substrate 902 and the interposer 806, in accordance with some embodiments. The wiring structure 806M of the interposer 806 may be electrically coupled to the wiring structure 902M of the substrate 902 through the conductive structures 808. The conductive structures 808 may be partially disposed in the second portion 806b of the interposer 806 to decrease the total thickness of the semiconductor package structure 800.

Then, a molding material 120 is formed between the interposer 806 and the substrate 902, in accordance with some embodiments. The molding material 120 may surround the semiconductor die 112, the adhesive layer 114, the underfill material 110, and the conductive structures 808. The sidewalls of the molding material 120 may be substantially coplanar with the sidewalls of the substrate 902 and the sidewalls of the interposer 806.

Afterwards, a plurality of conductive terminals 904 are formed below the substrate 902, in accordance with some embodiments. The conductive terminals 904 may be electrically coupled to the wiring structure 902M. The conductive terminals 904 may include microbumps, controlled collapse chip connection (C4) bumps, solder balls, ball grid array (BGA) balls, the like, or a combination thereof. In some embodiments, the conductive terminals 904 are formed of conductive materials, including tungsten, titanium, tantalum, ruthenium, cobalt, copper, aluminum, platinum, tin, silver, gold, the like, an alloy thereof, or a combination thereof.

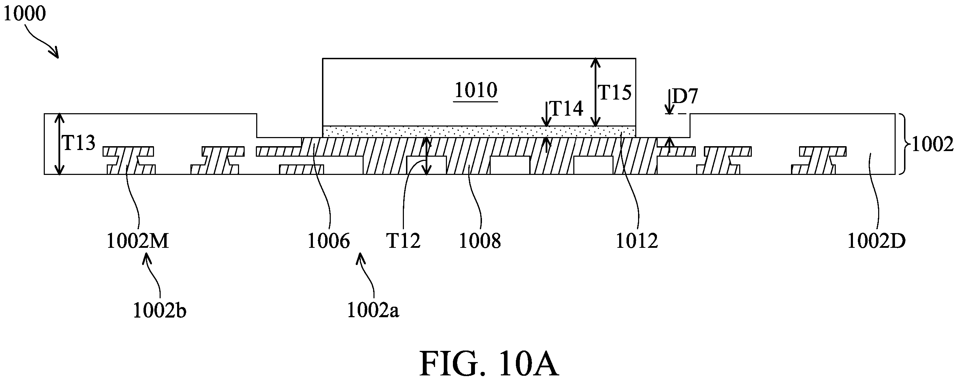

FIGs. 10A to 10C are cross-sectional views illustrating a semiconductor package structure 1000 at various stages of manufacture in accordance with some embodiments of the present disclosure. It should be noted that the semiconductor package structure 1000 may include the same or similar components as that of the semiconductor package structure 800, which is illustrated in FIG. 8B, and for the sake of simplicity, those components will not be discussed in detail again. In the following embodiments, a semiconductor die is disposed over an interposer before bonding the interposer onto a substrate.

As shown in FIG. 10A, an interposer 1002 is provided, in accordance with some embodiments. The interposer 1002 may have a wiring structure 1002M therein. In some embodiments, the wiring structure 1002M includes conductive layers, conductive vias, conductive pillars, the like, or a combination thereof. The wiring structure 1002M may be formed of metal, including copper, aluminum, tungsten, the like, an alloy thereof, or a combination thereof.

The wiring structure 1002M may be disposed in dielectric layers 1002D. The dielectric layers 1002D may be formed of polymers, including polyimide (PI), polybenzoxazole (PBO), benzocyclobutene (BCB), epoxy, the like, or a combination thereof. Alternatively, the dielectric layers 1002D may be formed of dielectric materials, including silicon oxide, silicon carbide, silicon nitride, silicon oxynitride, the like, or a combination thereof.

The interposer 1002 may include a cavity 1004. The cavity 1004 may have a depth D7. In some embodiments, the depth D7 is in a range of about 30 µm to about 90 µm, such as about 50 µm. The sidewalls of the cavity 1004 may be substantially vertical to the top surface of the interposer 1002, but the present disclosure is not limited thereto. For example, at least one of the sidewalls of the cavity 1004 may be tapered or sloped.

The interposer 1002 may have a first portion 1002a and a second portion 1002b, and the thickness T12 of the first portion 1002a may be less than the thickness T13 of the second portion 1002b in the direction substantially vertical to the top surface of the interposer 1002. In particular, the distance between the top surface of the second portion 1002b and the top surface of the first portion 1002a may be equal to the depth D7. The second portion 1002b may connect and surround the first portion 1002a. In some embodiments, the ratio of the thickness T12 of the first portion 1002a to the thickness T13 of the second portion 1002b is in a range of about 0.5 to about 0.65, such as about 0.62.

A heat spreader 1006 and a plurality of thermal vias 1008 are embedded in the first portion 1002a of the interposer 1002, in accordance with some embodiments. The thermal vias 1008 may be in direct contact with the heat spreader 1006. The top surface of the heat spreader 1006 may be exposed by the cavity 1004. In particular, the top surface of the heat spreader 1006 may be substantially aligned with the top surface of the first portion 1002a of the interposer 1002.

The heat spreader 1006 may be formed of metal, including copper, aluminum, tungsten, the like, an alloy thereof, or a combination thereof. The thermal vias 1008 may be formed of metal, including copper, aluminum, tungsten, the like, an alloy thereof, or a combination thereof. The material of the thermal vias 1008 may be similar to the material of the heat spreader 1006. The material of the heat spreader 1006 and the material of the thermal vias 1008 may be similar to wiring structure 1002M of the interposer 1002. The heat spreader 1006 and thermal vias 1008 may be formed during the formation of the wiring structure 1002M.

The bottom surface of the thermal vias 1008 may be exposed. The bottom surface of the thermal vias 814 may be substantially aligned with the bottom surface of the first portion 1002a and may be substantially aligned with the bottom surface of the second portion 1002b of the interposer 1002.

An adhesive layer 1012 and a semiconductor die 1010 are disposed in the cavity 1004, in accordance with some embodiments. The adhesive layer 1012 and the semiconductor die 1010 may be similar to the adhesive layer 114 and the semiconductor die 112 of the semiconductor package structure 800 in FIG. 8A, respectively, and will not be described in detail.

The adhesive layer 1012 and the semiconductor die 1010 may be disposed in the cavity 1004, thereby increasing the thickness of the semiconductor die 1010 to enhance the efficiency of thermal dissipation. In the direction substantially vertical to the top surface of the interposer 1002, the depth D7 of the cavity 1004 may be greater than the thickness T14 of the adhesive layer 1012 and may be less than the sum of the thickness T14 of the adhesive layer 1012 and the thickness T15 of the semiconductor die 1010.

The adhesive layer 1012 and the semiconductor die 1010 may vertically overlap the first portion 1002a of the interposer 1002. The adhesive layer 1012 may be in direct contact with the heat spreader 1006. The heat spreader 1006 and the thermal vias 1008 may be thermally coupled to the semiconductor die 1010. Thus, the heat from the thermal source (e.g., the semiconductor die 1010) can be transferred to the heat spreader 1006 through the adhesive layer 1012, and can be further transferred to the thermal vias 1008. Since the heat spreader 1006 and the thermal vias 1008 are formed of the material with a higher thermal conductivity than the interposer 1002, the efficiency of thermal dissipation can be improved.

The hot spot of the semiconductor die 1010 may be disposed directly above the heat spreader 1006. The heat spreader 1006 may have a projection area substantially equal to or greater than the hot spot of the semiconductor die 1010. In some embodiments, the heat spreader 1006 has a projection area substantially equal to or greater than the adhesive layer 1012 and/or the semiconductor die 1010. By increasing the area of the heat spreader 1006, the efficiency of thermal dissipation can be further improved. In addition, the number of the thermal vias 1008 can be increased accordingly.

It should be noted that the adhesive layer 1012 may be disposed on the semiconductor die 1010 and/or the interposer 1002 before bonding the interposer 1002 to the semiconductor die 1010, similar to those discussed above. Furthermore, the sidewalls of the adhesive layer 1012 may be substantially coplanar with the sidewalls of the semiconductor die 1010 as illustrated. Alternatively, the adhesive layer 1012 may extend outside the sidewalls of the semiconductor die 1010, or the adhesive layer 1012 may have sidewalls between the sidewalls of the semiconductor die 1010.

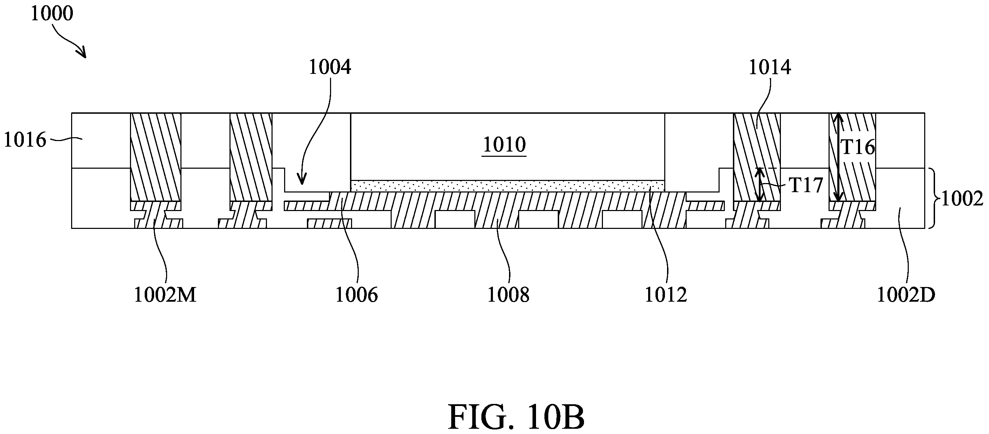

Then, as illustrated in FIG. 10B, a plurality of conductive structures 1014 are partially disposed in the second portion 1002b of the interposer 1002, in accordance with some embodiments. Consequently, the total thickness of the semiconductor package structure 1000 can be further decreased. For example, a plurality of openings (not illustrated) may be formed in the interposer 1002 by laser drilling or any suitable methods, and then the conductive structures 1014 may be formed in the openings.

In some embodiments, the conductive structures 1014 include conductive pillars to achieve fine via pitch and high input/output (I/O) pin counts. In some other embodiments, the conductive structures 1014 include copper core solder balls, solder balls, any suitable structures, or a combination thereof. The conductive structures 1014 may be formed of conductive materials, including copper, aluminum, tungsten, the like, an alloy thereof, or a combination thereof.

The topmost surface of the interposer 1002 (or the top surface of the second portion 1002b) may be disposed between the top surface and the bottom surface of the conductive structures 1014. In some embodiments, in the direction substantially vertical to the top surface of the interposer 1002, the ratio of the thickness T17 of a portion of one of the conductive structures 1014 in the second portion 1002b to the thickness T16 of the conductive structure 1014 is in a range of about 0.1 to about 0.35, such as about 0.15. Therefore, the thermal performance can be improved.

Then, a molding material 1016 is formed over the interposer 1002 and extends into the cavity 1006, in accordance with some embodiments. In some embodiments, the molding material 1016 is in direct contact with the top surface of the heat spreader 1006. The molding material 1016 may be formed of a nonconductive material, including a moldable polymer, an epoxy, a resin, the like, or a combination thereof. The molding material 1016 may surround the semiconductor die 1010, the adhesive layer 1012, and the conductive structures 1014 to protect these components from the environment, thereby protecting them from damage due to stress, chemicals, and moisture.

Afterwards, a planarization process is performed on the molding material 1016 until the top surfaces of the conductive structures 1014 and the semiconductor die 1010 are exposed, in accordance with some embodiments. The planarization process may include a chemical mechanical polishing (CMP) process, a mechanical grinding process, the like, or a combination thereof. The top surface of the molding material 1016, the top surfaces of the conductive pillars 1014, and the top surface of the semiconductor die 1010 may be substantially coplanar. The thickness of the molding material 1016 directly over the first portion 1002a of the interposer 1002 may be greater than the thickness of the molding material 1016 directly over the second portion 1002b of the interposer 1002.

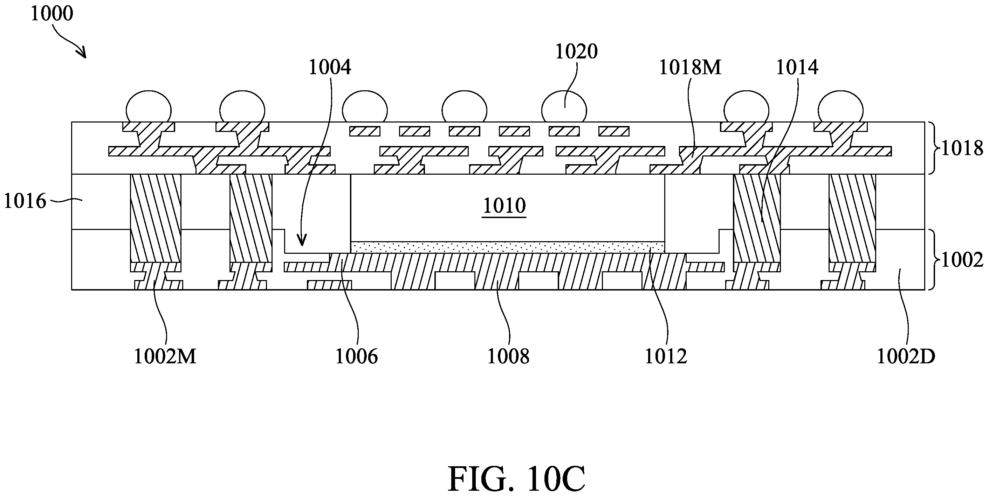

Then, as shown in FIG. 10C, a substrate 1018 is formed over the molding material 1016, in accordance with some embodiments. The substrate 1018 may be a redistribution structure. The substrate 1018 may have a wiring structure 1018M therein. In some embodiments, the wiring structure 1018M includes conductive layers, conductive vias, conductive pillars, the like, or a combination thereof. The wiring structure 1018Mmay be formed of metal, including copper, aluminum, tungsten, the like, an alloy thereof, or a combination thereof.

The wiring structure 1018M may be disposed in dielectric layers 1018D. The dielectric layers 1018D may be formed of polymers, including polyimide (PI), polybenzoxazole (PBO), benzocyclobutene (BCB), epoxy, the like, or a combination thereof. Alternatively, the dielectric layers 1018D may be formed of dielectric materials, including silicon oxide, silicon carbide, silicon nitride, silicon oxynitride, the like, or a combination thereof.

The wiring structure 1002M of the interposer 1002 may be electrically coupled to the wiring structure 1018M of the substrate 1018 through the conductive structures 1014. The sidewalls of the molding material 1016 may be substantially coplanar with the sidewalls of the substrate 1018 and the sidewalls of the interposer 1002.

Afterwards, a plurality of conductive terminals 1020 are disposed over the substrate 1018, in accordance with some embodiments. The conductive terminals 1020 may be electrically coupled to the wiring structure 1018M. The conductive terminals 1020 may include microbumps, controlled collapse chip connection (C4) bumps, solder balls, ball grid array (BGA) balls, the like, or a combination thereof. In some embodiments, the conductive terminals 1020 are formed of conductive materials, including tungsten, titanium, tantalum, ruthenium, cobalt, copper, aluminum, platinum, tin, silver, gold, the like, an alloy thereof, or a combination thereof.

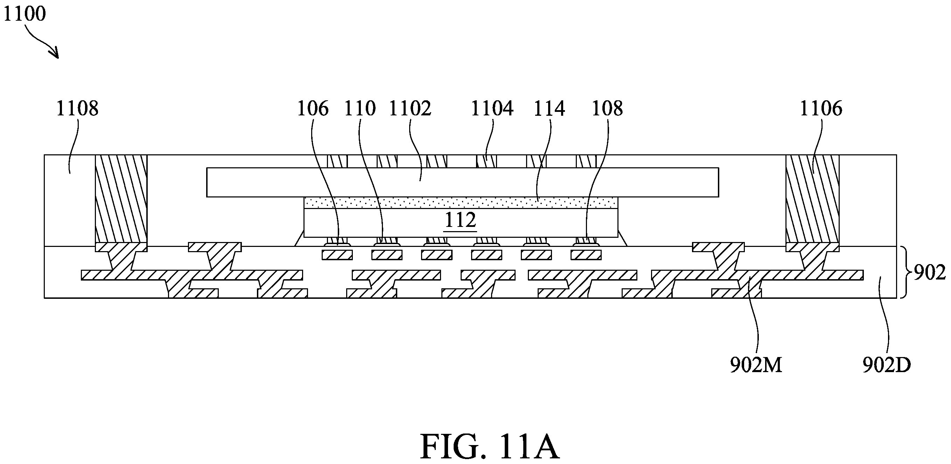

FIGs. 11A to 11B are cross-sectional views illustrating a semiconductor package structure 1100 at various stages of manufacture in accordance with some embodiments of the present disclosure. FIG. 11A may be subsequent to the step of the process that is illustrated in FIG. 9A, and the same or similar reference numbers are used to depict the same or similar components as those of the semiconductor package structure 900. For the sake of simplicity, those components will not be discussed in detail again. In the following embodiments, a heat spreader is disposed between redistribution structures.

As shown in FIG. 11A, a heat spreader 1102 is formed over the adhesive layer 114, in accordance with some embodiments. The adhesive layer 114 may be disposed on the semiconductor die 112 and/or the heat spreader 1102 before bonding the heat spreader 1102 to the semiconductor die 112. The heat spreader 1102 may vertically overlap the hot spot of the semiconductor die 112. Therefore, the heat from the thermal source (e.g., the semiconductor die 112) can be transferred to the heat spreader 1102 through the adhesive layer 114.

In some embodiments, the heat spreader 1102 includes a metal plate, a dummy semiconductor die, or a combination thereof. For example, the heat spreader 1102 may be formed of copper, aluminum, silicon, germanium, or any suitable materials. Since the heat spreader 1102 is formed of the material with a higher thermal conductivity than the molding material formed later, the efficiency of thermal dissipation can be enhanced. Moreover, the heat spreader 1102 can provide a stronger support than the molding material. As a result, the semiconductor package structure 1100 can have a better warpage behavior.

In some embodiments, the heat spreader 1102 has a projection area substantially equal to or greater than the adhesive layer 114 and/or the semiconductor die 112. By increasing the area of the heat spreader 1102, the efficiency of thermal dissipation can be further enhanced.

Then, a plurality of conductive structures 1104 are formed over the heat spreader 1102 and thermally coupled to the heat spreader 1102, in accordance with some embodiments. The conductive structures 1104 may include conductive pads, conductive pillars, the like, or a combination thereof. The conductive structures 1104 may be formed of conductive materials, including copper, aluminum, tungsten, titanium, tantalum, the like, an alloy thereof, or a combination thereof. The conductive structures 1104 may be formed by electroplating, electroless plating, or another applicable process.

Afterward, a plurality of conductive structures 1106 are disposed over the substrate 902, in accordance with some embodiments. In some embodiments, the conductive structures 1106 include conductive pillars. In some other embodiments, the conductive structures 1106 include copper core solder balls, solder balls, any suitable structures, or a combination thereof. The conductive structures 1106 may be formed of conductive materials, including copper, aluminum, tungsten, the like, an alloy thereof, or a combination thereof.

Then, a molding material 1108 is formed over the substrate 902, in accordance with some embodiments. The molding material 1108 may surround the semiconductor die 112, the adhesive layer 114, the heat spreader 1102, the conductive structures 1104, and the conductive structures 1106 to protect these components from the environment, thereby protecting them from damage due to stress, chemicals, and moisture. The molding material 1108 may be formed of a nonconductive material, including a moldable polymer, an epoxy, a resin, the like, or a combination thereof. The molding material 1108 may cover the top surface and the sidewalls of the heat spreader 1102.

Afterwards, a planarization process is performed on the molding material 1108 until the top surfaces of the conductive structures 1104 and the conductive structures 1106 are exposed, in accordance with some embodiments. The planarization process may include a chemical mechanical polishing (CMP) process, a mechanical grinding process, the like, or a combination thereof. The top surface of the molding material 1016, the top surfaces of the conductive structures 1104, and the top surfaces of the conductive structures 1106 may be substantially coplanar.

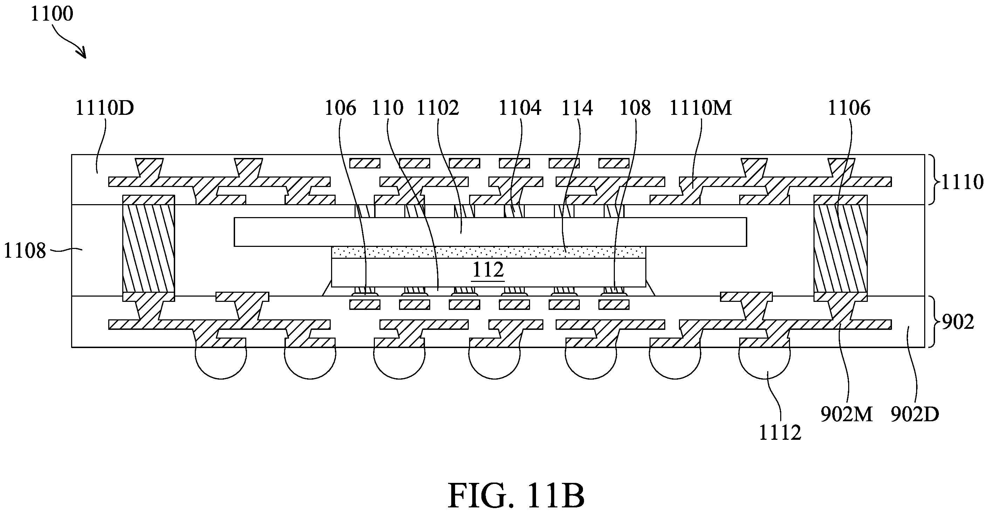

Then, as shown in FIG. 11B, a redistribution structure 1110 is formed over the molding material 1108, in accordance with some embodiments. In the embodiments where the substrate 902 is a redistribution structure, the substrate 902 may be referred to as a first redistribution structure, and the redistribution structure 1110 may be referred to as a second redistribution structure. The sidewalls of the molding material 1118 may be substantially coplanar with the sidewalls of the substrate 902 and the sidewalls of the redistribution structure 1110.

The redistribution structure 1110 may be thermally coupled to the semiconductor die 112 through the heat spreader 1102 and the conductive structures 1104. Thus, the heat transferred to the heat spreader 1102 from the thermal source (e.g., the semiconductor die 112) can be further transferred to the redistribution structure 1110.

The redistribution structure 1110 may have a wiring structure 1110M therein, which may be disposed in dielectric layers 1110D. The wiring structure 1110M and the dielectric layers 1110D may be similar to the wiring structure 902M and the dielectric layers 902D, respectively, and will not be described in detail. The wiring structure 1110M of the redistribution structure 1110 may be electrically coupled to the wiring structure 902M of the substrate 902 through the conductive structures 1116.

Afterwards, a plurality of conductive terminals 1112 are disposed below the substrate 902, in accordance with some embodiments. The conductive terminals 1112 may be electrically coupled to the wiring structure 902M. The conductive terminals 1112 may be similar to the conductive terminals 904 of the semiconductor package structure 900 in FIG. 9B, and will not be described in detail.

In summary, in some embodiments, the semiconductor package structure according to the present disclosure increase the thickness of the semiconductor die to gain power budget enhancement. Therefore, the efficiency of thermal dissipation can be enhanced, and thus the performance of the semiconductor package structure can be improved.

According to some embodiments, the semiconductor die reaches the interposer to shorten the heat dissipation path. The better warpage behavior and fewer (or without) voids can be achieved as well. In addition, the interposer has a mesa structure to facilitate heat transfer from the semiconductor die, according to some embodiments. According to some embodiments, the top surface of the semiconductor die is exposed for better thermal dissipation.

In some embodiments, the semiconductor package structure according to the present disclosure includes a heat spreader disposed in an interposer. The heat spreader vertically overlaps the thermal source. Therefore, the efficiency of thermal dissipation can be improved.

According to some embodiments, an interposer includes a cavity, so that the thickness of the semiconductor die can be increased. Consequently, the efficiency of thermal dissipation can be further increased, and the warpage behavior of the semiconductor package structure can be improved. According to some embodiments, a plurality of conductive structures are partially disposed in the interposer, thereby decreasing the total thickness of the semiconductor package structure.

While the invention has been described by way of example and in terms of the preferred embodiments, it should be understood that the invention is not limited to the disclosed embodiments. On the contrary, it is intended to cover various modifications and similar arrangements (as would be apparent to those skilled in the art). Therefore, the scope of the appended claims should be accorded the broadest interpretation so as to encompass all such modifications and similar arrangements.

The present invention may also be defined by the following numbered clauses.
1. A semiconductor package structure, comprising:
   a substrate;
   a semiconductor die disposed over the substrate;
   an interposer disposed over the semiconductor die and having a cavity;
   a heat spreader embedded in the interposer and vertically overlapping the semiconductor die; and
   an adhesive layer disposed in the cavity and connecting the semiconductor die to the heat spreader.
2. The semiconductor package structure of clause 1, further comprising a molding material surrounding the semiconductor die and the adhesive layer and extending into the cavity.
3. The semiconductor package structure of clause 2, further comprising a plurality of conductive structures disposed between the substrate and the interposer and surrounded by the molding material.
4. The semiconductor package structure of clause 3, wherein the conductive structures are partially disposed in the interposer.
5. The semiconductor package structure of clause 3, wherein the conductive structures comprise conductive pillars, solder balls, copper core solder balls, or a combination thereof.
6. The semiconductor package structure of clause 1, wherein the substrate comprises a package substrate.
7. The semiconductor package structure of clause 1, wherein the substrate comprises a redistribution structure.
8. The semiconductor package structure of clause 1, further comprising a plurality of thermal vias embedded in the interposer and thermally coupled to the heat spreader.
9. A semiconductor package structure, comprising:
   a substrate;
   a semiconductor die disposed over the substrate;
   an interposer comprising:
      a first portion covering the semiconductor die; and
      a second portion connecting the first portion and thicker than the first portion;
      a heat spreader disposed in the first portion of the interposer; and
      a conductive structure partially disposed in the second portion of the interposer and electrically coupling the substrate and the interposer.
10. The semiconductor package structure of clause 9, further comprising a plurality of thermal vias disposed in the first portion of the interposer and thermally coupled to the heat spreader.
11. The semiconductor package structure of clause 10, wherein the thermal vias and the heat spreader are formed of metal.
12. The semiconductor package structure of clause 10, wherein a top surface of the thermal vias is substantially aligned with a top surface of the first portion of the interposer and a top surface of the second portion of the interposer.
13. The semiconductor package structure of clause 9, wherein a bottom surface of the heat spreader is substantially aligned with a bottom surface of the first portion of the interposer.
14. The semiconductor package structure of clause 9, further comprising an adhesive layer in contact with the semiconductor die and the heat spreader.
15. The semiconductor package structure of clause 9, wherein the heat spreader has a projection area substantially equal to or greater than the adhesive layer and/or the semiconductor die.
16. A semiconductor package structure, comprising:
   a first redistribution structure;
   a semiconductor die disposed over the first redistribution structure;
   an adhesive layer disposed over the semiconductor die;
   a heat spreader disposed over the adhesive layer and vertically overlapping the semiconductor die;
   a second redistribution structure disposed over the heat spreader; and
   a molding material surrounding the semiconductor die, the adhesive layer, and the heat spreader.
17. The semiconductor package structure of clause 16, further comprising a plurality of conductive structures thermally coupling the heat spreader and the second redistribution structure and surrounded by the molding material.
18. The semiconductor package structure of clause 16, further comprising a conductive pillar electrically coupling the first redistribution structure and the second redistribution structure and surrounded by the molding material.
19. The semiconductor package structure of clause 16, wherein the heat spreader has a larger projection area than the adhesive layer and/or the semiconductor die.
20. The semiconductor package structure of clause 16, further comprising:
   a plurality of conductive terminals disposed below the first redistribution structure;
   a plurality of conductive structures disposed between the semiconductor die and the first redistribution structure; and
   an underfill material surrounding the plurality of conductive structures .

## Claims

1. A semiconductor package structure (100, 200, 300, 400, 500, 600, 700, 800, 900, 1000, 1100), comprising:
a substrate (102, 802, 902, 1018);
a semiconductor die (112, 1010) disposed over the substrate (102, 802, 902, 1018);
an interposer (118, 806, 1002) disposed over the semiconductor die (112, 1010) and having a cavity (502, 810, 1004);
a heat spreader (812, 1006, 1102) embedded in the interposer (118, 806, 1002) and vertically overlapping the semiconductor die (112, 1010); and
an adhesive layer (114, 114a, 114b, 1012) disposed in the cavity (502, 810, 1004) and connecting the semiconductor die (112, 1010) to the heat spreader (812, 1006, 1102).

2. The semiconductor package structure (100, 200, 300, 400, 500, 600, 700, 800, 900, 1000, 1100) as claimed in claim 1, further comprising a molding material (120, 1016, 1108, 1118) surrounding the semiconductor die (112, 1010) and the adhesive layer (114, 114a, 114b, 1012) and extending into the cavity (502, 810, 1004).

3. The semiconductor package structure (100, 200, 300, 400, 500, 600, 700, 800, 900, 1000, 1100) as claimed in claim 2, further comprising a plurality of conductive structures (108, 116, 808, 1014, 1104, 1106, 1116) disposed between the substrate (102, 802, 902, 1018) and the interposer (118, 806, 1002) and surrounded by the molding material (120, 1016, 1108, 1118).

4. The semiconductor package structure (800, 1000) as claimed in claim 3, wherein the conductive structures (808, 1014) are partially disposed in the interposer (806, 1002).

5. The semiconductor package structure (100, 200, 300, 400, 500, 600, 700, 800, 900, 1000, 1100) as claimed in claim 3, wherein the conductive structures (108, 116, 808, 1014, 1104, 1106, 1116) comprise conductive pillars, solder balls, copper core solder balls, or a combination thereof.

6. The semiconductor package structure (100, 200, 300, 400, 500, 600, 700, 800) as claimed in claim 1, wherein the substrate (102, 802) comprises a package substrate.

7. The semiconductor package structure (900, 1000) as claimed in claim 1, wherein the substrate (902, 1018) comprises a redistribution structure.

8. The semiconductor package structure (100, 200, 300, 400, 500, 600, 700, 800, 900, 1000, 1100) as claimed in claim 1, further comprising a plurality of thermal vias (814, 1008) embedded in the interposer (118, 806, 1002) and thermally coupled to the heat spreader (812, 1006, 1102).

9. A semiconductor package structure (800, 900, 1000), comprising:
a substrate (802, 902, 1018);
a semiconductor die (112, 1010) disposed over the substrate (802, 902, 1018);
an interposer (806, 1002) comprising:
a first portion (806a, 1002a) covering the semiconductor die (112, 1010); and
a second portion (806b, 1002b) connecting the first portion (806a, 1002a) and thicker than the first portion (806a, 1002a);
a heat spreader (812, 1006) disposed in the first portion (806a, 1002a) of the interposer (806, 1002); and
a conductive structure (808, 1014) partially disposed in the second portion (806b, 1002b) of the interposer (806, 1002) and electrically coupling the substrate (802, 1018) and the interposer (806, 1002).

10. The semiconductor package structure (800, 900, 1000) as claimed in claim 9, further comprising a plurality of thermal vias (814, 1008) disposed in the first portion (806a, 1002a) of the interposer (806, 1002) and thermally coupled to the heat spreader (812, 1006, 1102).

11. The semiconductor package structure (800, 900, 1000) as claimed in claim 10, wherein the thermal vias (814, 1008) and the heat spreader (812, 1006, 1102) are formed of metal; or
wherein a top surface of the thermal vias (814, 1008) is substantially aligned with a top surface of the first portion (806a, 1002a) of the interposer (806, 1002) and a top surface of the second portion (806b, 1002b) of the interposer (806, 1002).

12. The semiconductor package structure (800, 900, 1000) as claimed in claim 9, wherein a bottom surface of the heat spreader (812, 1006, 1102) is substantially aligned with a bottom surface of the first portion (806a, 1002a) of the interposer (806, 1002); or
wherein the semiconductor package structure further comprises an adhesive layer (114, 114a, 114b, 1012) in contact with the semiconductor die (112, 1010) and the heat spreader (812, 1006, 1102); or
wherein the heat spreader (812, 1006, 1102) has a projection area substantially equal to or greater than the adhesive layer (114, 114a, 114b, 1012) and/or the semiconductor die (112, 1010).

13. A semiconductor package structure (1100), comprising:
a first redistribution structure (902);
a semiconductor die (112) disposed over the first redistribution structure (902);
an adhesive layer (114) disposed over the semiconductor die (112);
a heat spreader (1102) disposed over the adhesive layer (114) and vertically overlapping the semiconductor die (112);
a second redistribution structure (1110) disposed over the heat spreader (1102); and
a molding material (1108) surrounding the semiconductor die (112), the adhesive layer (114), and the heat spreader (1102).

14. The semiconductor package structure (1100) as claimed in claim 13, further comprising a plurality of conductive structures (1104) thermally coupling the heat spreader (1102) and the second redistribution structure (1110) and surrounded by the molding material (1108); or
further comprising a conductive pillar (1106) electrically coupling the first redistribution structure (902) and the second redistribution structure (1110) and surrounded by the molding material (1108); or
wherein the heat spreader (1102) has a larger projection area than the adhesive layer (114) and/or the semiconductor die (112).

15. The semiconductor package structure (1100) as claimed in claim 13, further comprising:
a plurality of conductive terminals (1112) disposed below the first redistribution structure (902);
a plurality of conductive structures (108) disposed between the semiconductor die (112) and the first redistribution structure (902); and
an underfill material (110) surrounding the plurality of conductive structures (108).
